# EUROPEAN PATENT APPLICATION

(11) **EP 4 790 433 A1**
(43) Date of publication of application: **12.08.2026**
(21) Application number: 26152634.7
(22) Date of filing: 19.01.2026
(51) Int. Cl.: G01R 31/00, H02H 1/00

(54) **SYSTEMS AND METHODS FOR DETECTION OF ELECTRICAL ARCS AND ELECTRICAL COMPONENT FAILURE IN POWER DISTRIBUTION SYSTEMS**

(30) Priority: 07.02.2025 US 202519048624
(71) Applicant: GE Aviation Systems Limited, Cheltenham Gloucestershire GL52 8SF (GB)
(72) Inventor: CLAY, Thomas, Cheltenham, GL52 8SF (GB)
(74) Representative: Openshaw & Co.

(57) **Abstract**

Systems and methods for early detection of electrical arcs or electrical component failures in enclosed modules are provided. A system (100, 200) for detecting electrical component failures or electrical arcs includes: an enclosed module (102, 202) including electrical components (110); a light sensor (118, 218A) in the enclosed module (102, 202) detecting light emitted within the enclosed module (102, 202); and a control circuit (122, 222) operatively coupled to the light sensor (118, 218A), the control circuit (122, 222) triggering a predetermined action upon detection of light in excess of a predetermined light threshold level or detection of predetermined light activity by the light sensor (118, 218A). The predetermined action may include triggering an alert and/or a switch (120, 220) addressing the detection of a possible electrical discharge in the enclosed module (102, 202).

## Description

### TECHNICAL FIELD

These teachings relate generally to electrical power distribution systems, and specifically to electrical discharge and component failure detection and prevention in power distribution units.

### BACKGROUND

Power distribution units are used in various contexts to distribute electrical power to multiple separate systems. These power distribution units often include electrical and/or electronic components that may fail or malfunction, which may lead them to produce electrical arcs, sparks, discharge, and/or other indications of failure within the power distribution unit. In turn, this failure or malfunction may affect other electrical and/or electronic components in the power distribution unit.

For example, aircraft electrical distribution systems may experience electrical arcs, sparks, discharge, and/or other indications of failure in power distribution units that distribute power to various aviation systems. Newer electrical systems may use higher voltages and currents, which may increase the likelihood of potential component failure occurring and may increase the consequences of such a failure. If not detected and addressed early, this failure event might spread and result in damage to or failure of other components in the unit and/or outside the unit. Accordingly, it is desirable for early detection to minimize damage that might result from this event.

### BRIEF DESCRIPTION OF DRAWINGS

Various needs are at least partially met through provision of early component failure detection described in the following detailed description, particularly when studied in conjunction with the drawings. A full and enabling disclosure of the aspects of the present description, including the best mode thereof, directed to one of ordinary skill in the art, is set forth in the specification, which refers to the appended figures, in which:
FIG. 1 is a schematic view of an electrical power distribution system in accordance with various embodiments;
FIG. 2 is a schematic view of electrical components in an enclosed module in accordance with various embodiments;
FIG. 3 is a schematic view of a system for detecting electrical component failure in accordance with various embodiments;
FIG. 4 is a schematic view of a system for detecting electrical component failure in accordance with various embodiments;
FIG. 5 is a schematic view of a system for detecting electrical component failure in accordance with various embodiments;
FIG. 6 is a schematic view of a system for detecting electrical component failure in accordance with various embodiments;
FIG. 7 is a schematic view of a system for detecting smoke, soot, or particulates within enclosed modules in accordance with various embodiments;
FIG. 8 is a schematic view of a system for detecting smoke, soot, or particulates within enclosed modules in accordance with various embodiments;
FIG. 9 is a schematic view of a system for detecting smoke, soot, or particulates within enclosed modules in accordance with various embodiments;
FIG. 10 is a graph in accordance with various embodiments;
FIG. 11 is a flow diagram of a process in accordance with various embodiments; and
FIG. 12 is a flow diagram of a process in accordance with various embodiments.

Elements in the figures are illustrated for simplicity and clarity and have not necessarily been drawn to scale. For example, the dimensions and/or relative positioning of some of the elements in the figures may be exaggerated relative to other elements to help to improve understanding of various embodiments of the present teachings. Also, common but well-understood elements that are useful or necessary in a commercially feasible embodiment are often not depicted in order to facilitate a less obstructed view of these various embodiments of the present teachings. Certain actions and/or steps may be described or depicted in a particular order of occurrence while those skilled in the art will understand that such specificity with respect to sequence is not actually required.

### DETAILED DESCRIPTION

The following embodiments illustrate approaches for the early detection and prevention of component failure in power distribution units. The probability of failure of electronic components within an electrical distribution system increases as voltages and current increase. The approaches described in this disclosure are advantageous for high-voltage, high-current applications, such as for aircraft applications. In some embodiments, the system can help detect arcing components that may cause sparks or discharge within an enclosed power distribution unit.

In some embodiments, the system can help detect smoke, soot, and/or particulates that may result from a component failure or malfunction within an enclosed power distribution unit. Smoke, soot, and/or particulates may cause a suspension of carbon or other particles in air, which are typically emitted from a burning substance. Further, they may have fine particles with a diameter less than about 2.5 micrometers and may have a density in the range of about 5-30 micrograms per cubic meter (µg/m3). In some embodiments, the system may also help to detect other gases that may result from smoldering components, such as, for example, certain vapor, carbon dioxide, etc. In some embodiments, built-in-test (BIT) components for a light-based arc fault detection system may be incorporated to perform a self-diagnostic on the detection system.

Low-cost components may be used to achieve this early component detection and self-diagnostic within the power distribution unit. In turn, this early detection of a component failure may help prevent failure of other components inside and outside the power distribution unit. This approach therefore may provide a low cost approach for early detection and may provide comparable miniaturized solutions for various types of electrical distribution systems.

The terms and expressions used herein have the ordinary technical meaning as is accorded to such terms and expressions by persons skilled in the technical field as set forth above except where different specific meanings have otherwise been set forth herein. The word "or" when used herein shall be interpreted as having a disjunctive construction rather than a conjunctive construction unless otherwise specifically indicated. The terms "coupled," "fixed," "attached to," and the like refer to both direct coupling, fixing, or attaching, as well as indirect coupling, fixing, or attaching through one or more intermediate components or features, unless otherwise specified herein.

The singular forms "a", "an", and "the" include plural references unless the context clearly dictates otherwise. Reference throughout this specification to "one embodiment," "an embodiment," "some embodiments", "one form," "a form," "some forms", "an implementation", "some implementations", "some applications", or similar language means that a particular feature, structure, or characteristic described in connection with the embodiment is included in at least one embodiment of the present disclosure. It does not mean that the particular feature, structure, or characteristic is required in all embodiments of this disclosure.

Approximating language, as used herein throughout the specification and claims, is applied to modify any quantitative representation that could permissibly vary without resulting in a change in the basic function to which it is related. Accordingly, a value modified by a term or terms such as "about", "approximately", and "substantially", are not to be limited to the precise value specified. In at least some instances, the approximating language may correspond to the precision of an instrument for measuring the value, or the precision of the methods or machines for constructing or manufacturing the components and/or systems. For example, the approximating language may refer to being within a 10 percent margin.

The terms "electrical components," "electronic components," and "electrical and/or electronic components" are generally used interchangeably in this disclosure. It should generally be understood that any of a variety of different types of electrical and/or electronic components may be used within a power distribution unit. For example, in some forms, these components may include any suitable combination of solid state power controllers and other controllers, Metal-Oxide Semiconductor Field-Effect Transistors (MOSFETs) and other transistors, capacitors, resistors, inductors, etc. These components are well known in the art and require no further elaboration.

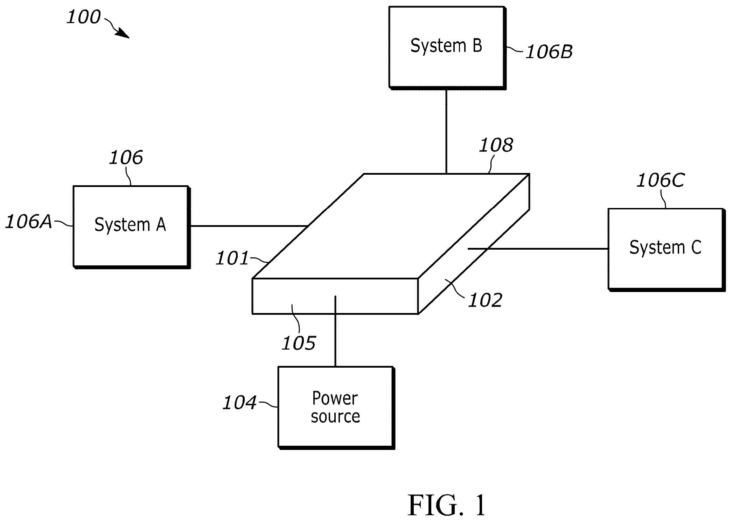

The foregoing and other benefits may become clearer upon making a thorough review and study of the following detailed description. FIG. 1 shows a power distribution unit 101 containing electrical and/or electronic components that is part of an electrical distribution system 10. Electrical distribution systems 10, such as in aircraft, may use power from one or more sources and distribute power to one or more loads. Power sources may be primary sources, such as, for example, batteries or power cells, or may be outputs of other parts of the overall system. Loads mays utilize power or may be an intermediate stage in the overall system.

In some embodiments, the power distribution unit 101 is in the form of an enclosed module 102 that houses the electrical and/or electronic components therein. The power distribution unit 101 may be coupled to a power source 104 via a power input interface 105. The module 102 may also be coupled to, and distribute power to, multiple systems, or loads 106, such as System A, System B, and System C, via multiple power output interfaces 108. In other words, the power distribution unit 101 may be operatively coupled to the power source 104 and the plurality of loads 106A, 106B, and 106C. It should be understood that the electrical distribution system 10 is shown at a schematic level and may include other aspects and components that are not necessary for an understanding of this subject matter.

In some forms, the enclosed module 102 may be a dark and/or sealed unit without any light from outside of the enclosed module 102 entering the enclosed module 102. In some forms, the primary light inside of the enclosed module 102 may be cast by components, which either intentionally (e.g., a light source) and/or unintentionally (e.g., an arcing component) emit light. It is generally contemplated that the enclosed module 102 may generally be formed from any suitable metal material but other non-conductive materials may be used.

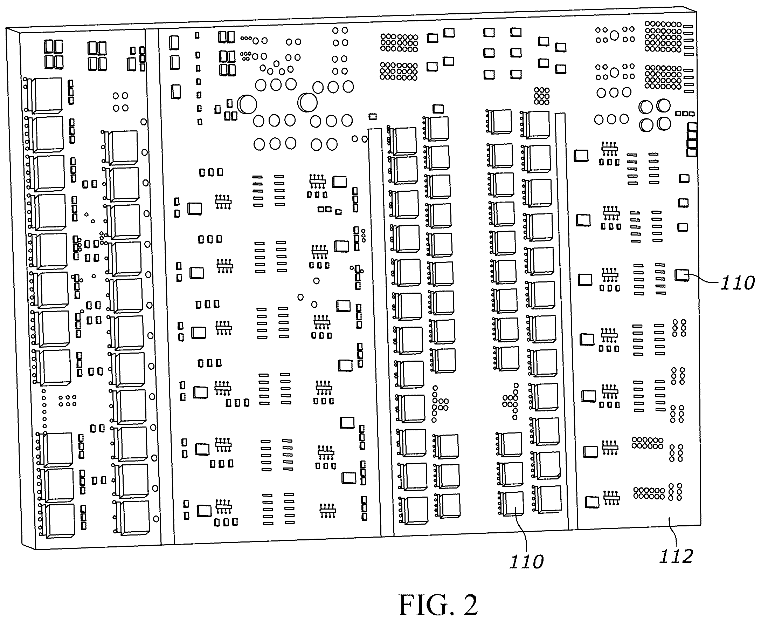

FIG. 2 shows an example of electrical components 110 of the enclosed module 102 in accordance with some embodiments. In some embodiments, the enclosed module 102 may further include a circuit board 112, such as, for example, a printed circuit board, and some or all of the electrical components 110 may be mounted on one or both sides of the circuit board 112. In some embodiments, as stated earlier, the electrical components 110 of the enclosed module 102 may be any of numerous types of electrical components 110 that are well known in the art.

It should be understood that the enclosed module 102 may include multiple circuit boards 112 and multiple sets of electrical components 110. In one form, each set of electrical components 110 may be mounted to a corresponding circuit board 112 in an enclosed module 102. As another example, light source(s) and/or light sensor(s) may be mounted on some or all of multiple circuit boards 112 in the enclosed module 102. Although this disclosure generally addresses one circuit board, its teachings and embodiments are also applicable to multiple circuit boards 112.

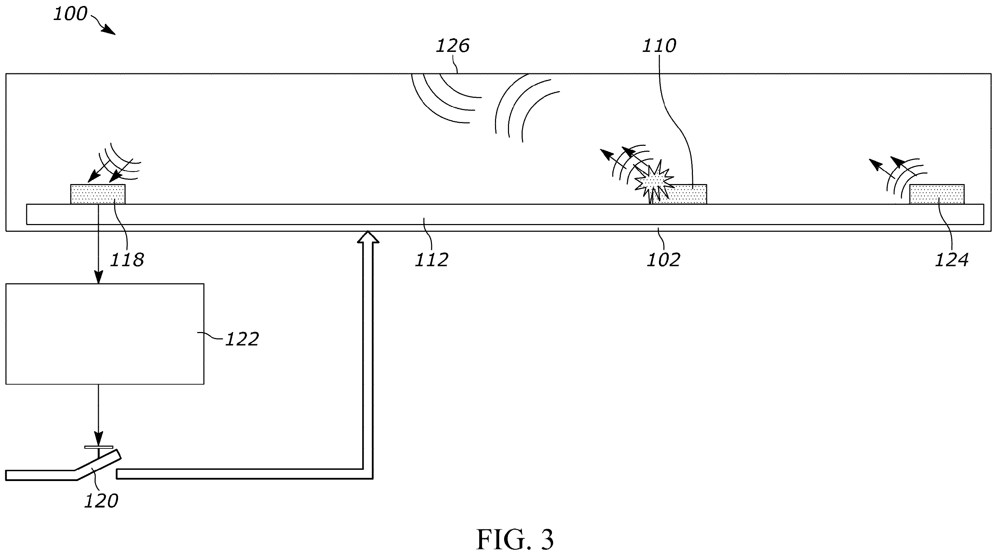

FIGS. 3-6 show an example of a component failure detection system (herein, a system 100) in accordance with some embodiments. In this form, a light sensor 118 in the enclosed module 102 is used to detect light from an arcing or sparking component, or any other light that may result from an ignition, and when light is detected, it triggers any of various types of actions. It is generally contemplated that low-cost light sensors 118 may be used, resulting in a relatively low overall cost for the system 100. By early detection of a component failure, this condition may be prevented from spreading to other components in the enclosed module 102 or from spreading outside the enclosed module 102.

FIG. 3 shows a schematic view of the system 100 in accordance with some embodiments. In some forms, the system 100 includes the enclosed module 102, a light sensor 118, and a control circuit 122. It is generally contemplated that the light sensor 118 in the enclosed module 102 detects light emitted by electrical components within the enclosed module 102. In some forms, the light sensor 118 may be mounted on a circuit board 112 in the enclosed module 102. In some forms, the light sensor 118 in combination with the control circuit 122 react in response to detection of light in excess of a predetermined light threshold level or detection of certain light activity. The light sensor 118 may be in the form of, without limitation, any photodiode, photoresistor, phototransistor, or other type of light sensor suitable for use within the enclosed module 102.

In some embodiments, the light sensor 118 may uninterruptedly monitor visible background light in the enclosed module 102. In other words, in some forms, the light sensor 118 continuously monitors the inside of the enclosed module 102 for light. In other forms, the light sensor 118 may monitor the inside of the enclosed module 102 periodically at predetermined time intervals and/or frequencies, such as, for example, every minute.

Once the light sensor 118 detects light exceeding a predetermined light threshold level or satisfying a predetermined light activity, then the control circuit 122 triggers a predetermined response. In other words, the control circuit 122 is operatively coupled to the light sensor 118 and triggers the predetermined action upon detection of light in excess of a predetermined light threshold level or detection of certain light activity by the first light sensor. In one form, the predetermined action may be in the form of transmitting an alert indicating detection of the predetermined light threshold level or activity by the first light sensor. This alert may be transmitted to one of systems shown in Figure 1, e.g., Systems A, B, or C. Alternatively, or in addition, this alert may be transmitted to a centralized location, such as, for example, to the cockpit of an airplane. Also, the alert may be in any of various forms, such as, for example, a visual alert (such as flashing or steady light indicator) and/or an audio alert (such as an alarm of a certain volume and/or frequency). It is generally contemplated that this alert may then result in an immediate action taken in response, such as, for example, some form of check on the status of the power distribution unit 101 or shutdown of the power distribution unit 101. In one form, this shutdown may be triggered from the cockpit, such as via a mechanical switch.

In some embodiments, such as shown in FIG. 3, the predetermined action may be an automated response to stop the supply of electrical power to the power distribution unit 101, such as, for example, through the use of a switch 120. In one form, the switch 120 allows electrical power to be transmitted to the enclosed module 102 when in a first closed position but does not allow electrical power to be transmitted to the enclosed module 102 when in a second open position. In other words, when the switch 120 is in the closed position, the enclosed module 102 and the electrical components 110 within the enclosed module 102 receive power, and when the switch 120 is in the open position, the enclosed module 102 and the electrical components 110 within the enclosed module 102 do not receive power. It is generally contemplated that any of various types of electrical or electronic or other types of switches may be used. It should also be understood that the predetermined action may include a combination of alert(s), switch(es), and/or other actions.

**In** this form, the control circuit 122 is operatively coupled to the light sensor 118 and the switch 120. **In** this context, the term control circuit refers broadly to any microcontroller, computer, or processor-based device with processor, memory, and programmable input/output peripherals, alone or in combination, which is generally designed to govern the operation of other components and devices. It is further understood to include common accompanying accessory devices, including external memory, transceivers for communication with other components and devices, etc. These architectural options are well known and understood in the art and require no further description here. The control circuit may be configured (for example, by using corresponding programming, instructions, and algorithms stored in a memory as will be well understood by those skilled in the art) to conduct one or more of the steps, actions, and/or functions described herein.

The control circuit may include a memory and a network interface for accessing a wireless network(s). The memory can, for example, store non-transitorily computer instructions that cause the control circuit to operate as described herein, when the instructions are executed. Further, the network interface may enable the control circuit to communicate with other elements (both internal and external to the system 100), as is well understood in the art. The network interface can communicatively couple the control circuit to the wireless network and whatever other networks may be appropriate for the circumstances. The control circuit may make use of and/or operate in conjunction with databases. **In** some forms, the functionalities of the control circuit may be implemented on a plurality of processor devices, such as, for example, communicating with one another on a network.

It is generally contemplated that this approach detects a situation where an electrical component in the enclosed module 102 causes electrical arcing, sparking, or discharge. This approach utilizes the fact that this sort of electrical discharge emits light within the enclosed module 102. **It** is generally contemplated that the dark interior of the enclosed module 102 facilitates light detection. Further, in some embodiments, the enclosed module 102 may further include one or more interior surfaces 126 that are configured to reflect emitted light so as to further facilitate light detection by the light sensor 118.

The control circuit 122 triggers an action based on the detection of light in excess of a certain light threshold level or detection of certain light activity by the light sensor 118. The light sensor 118 may detect a measured light intensity, or light level. It is generally contemplated that the system 100 may be set up to accommodate any of various types of light threshold levels or light activity detected by the light sensor 118. These light threshold levels or light activity may include, without limitation, detection of a light level exceeding the threshold for any amount of time (e.g., for even the briefest measurable moment) or for a certain length of time (e.g., for a longer period of time), detection of a light level exceeding the threshold as averaged over a certain time period, or detection of a certain rate of change in the light level. In one form, the light sensor 118 may be a light detector that is triggered once the detected light exceeds a single detection level, and the threshold may be this single detection level. In other forms, the light sensor 118 may measure different levels of detected light. It may be set at a minimum level of detection of the light sensor 118, such as, for example, 50 Lux, or it may be set to a higher level to seek to avoid false positive action, such as, for example, 100-500 Lux. In one form, detection of this light level or activity may trigger an alert.

In another form, in connection with the use of a switch 120, the control circuit 122 may trigger the switch 120 to the open position upon detection of a light intensity in excess of the light threshold level or detection of certain light activity by the light sensor 118. In some examples, the control circuit 122 may trigger the switch 120 to the open position when the detected light exceeds a predetermined light threshold level as measured over any amount of time or over a predetermined length of time. In some forms, the control circuit 122 may trigger the switch 120 to the open position when the average value of the detected light exceeds a certain light threshold level. In some embodiments, the control circuit 122 of the system 100 may trigger the switch 120 to the open position when the detected light level, or intensity, changes faster than a certain threshold rate of change. It is generally preferably that the control circuit 122 trigger the predetermined action, such as transmitting an alert and/or activating a switch, immediately so as to avoid the spread of the arcing, sparking, or discharge to other components in the power distribution unit 101 or to other systems outside of the power distribution unit 101.

In some embodiments, the enclosed module 102 of the system 100 may further include a light source 124 acting as a built-in test, or diagnostic, of the light sensor 118 with the light source 124 emitting, for example, a pulse of light at periodic time intervals within the enclosed module 102. The light source 124 may test the functionality and operation of the light sensor 118. In some forms, the light source 124 may be in the form of any suitable LED and/or laser. It is generally contemplated that a low-cost light source 124 may be used that is suitable for operation in an enclosed module 102. In some embodiments, the control circuit 122 may signal an alert (such as, for example, to a cockpit of an airplane) when the light sensor 118 fails to respond to the light emitted by the light source 124 over a predetermined length of time. Further, although FIG. 3 shows a single light sensor 118 and a single light source 124, it should be understood that additional light sensors and light sources may be used in the enclosed module 102 to facilitate early detection of component failure.

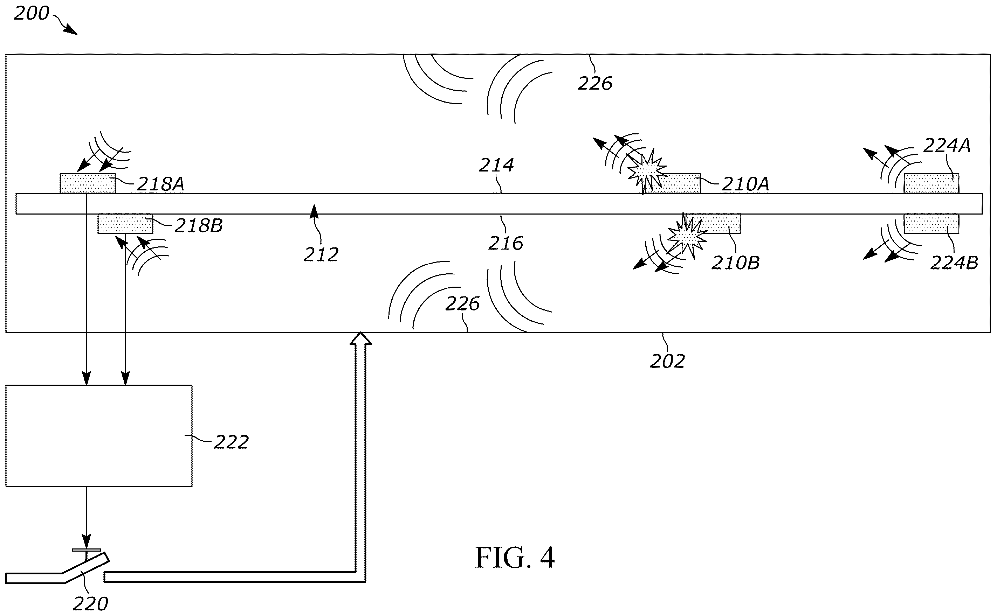

FIG. 4 shows another example of an early detection system 200 in accordance with some embodiments. In this form, the circuit board 212 may be double-sided, e.g., it includes a first side 214 and a second side 216. In some examples, the first side 214 and the second side 216 may each mount a light sensor(s) 218A, 218B and a respective set of electrical components 210A, 210B. For example, in some forms, a first light sensor 218A, electrical component(s) 210A, and/or a light source 224A may each be mounted on the first side 214 of the circuit board 212. Further, in some forms, a second light sensor 218B, electrical component(s) 210B, and/or a light source 224B may each be mounted on the second side 216 of the circuit board 212. Light from an arcing electrical component 210A, 210B on either the first side 214 or the second side 216 of the circuit board 212 may reflect off a respective interior surface 226.

As with the system 100, it is generally contemplated that each light sensor 218A, 218B may act in combination with a control circuit 222 to trigger a predetermined action. For example, this predetermined action may be in the form of transmitting an alert and/or tripping a switch 220 to disable power to the enclosed module 202. Further, in this form, it should be generally understood that any alternate suitable number, type, and/or configuration of components may be used, such as, for example, additional light sensors and/or light sources.

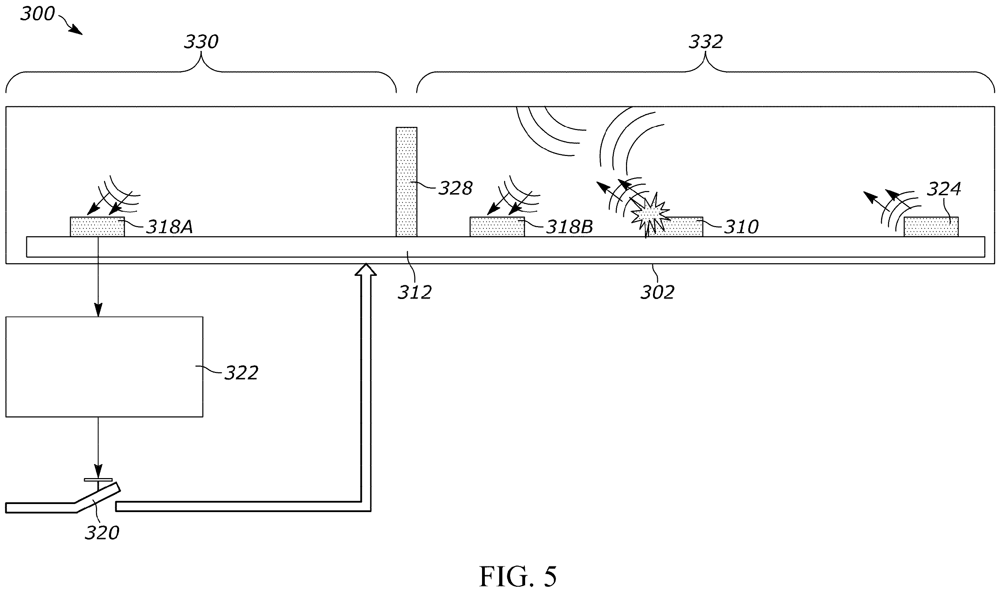

FIG. 5 shows an early detection system 300 where multiple light sensors may be used to address a barrier in the enclosed module. In some forms, the circuit board 312 may support a barrier 328 that acts to divide the circuit board 312 into a first area 330 and a second area 332. This barrier 328 may be an intended barrier, such as a wall specifically erected to separate different areas, or it may be a barrier 328 that is an unintended barrier, such as a structure that simply blocks a certain area in the enclosed module 302. In some embodiments, a first light sensor 318A may be mounted in the first area 330 and detect light emitted by electrical components 310 in the first area 330. In some forms, a second light sensor 318B may be mounted in the second area 332 and detect light emitted by electrical components 310 in the second area 332.

While the embodiment shown in FIG. 5 includes a first light sensor 318A in the first area 330 and a second light sensor 318B, an electrical component 310, and a light source 324 in the second area 332, it should be generally understood that any alternate suitable number, type, and/or configuration of components may be used. For example, in some forms, one or both areas may include a light source 324 that operates as a built-in test of the corresponding light sensor 318A, 318B in its area. Also, as with the earlier systems, it is generally contemplated that each light sensor 318A, 318B may operate in combination with one or more control circuits 322 to trigger a predetermined action, such as, without limitation, transmitting an alert and/or triggering a switch 320 to discontinue the supply of power to the enclosed module 302.

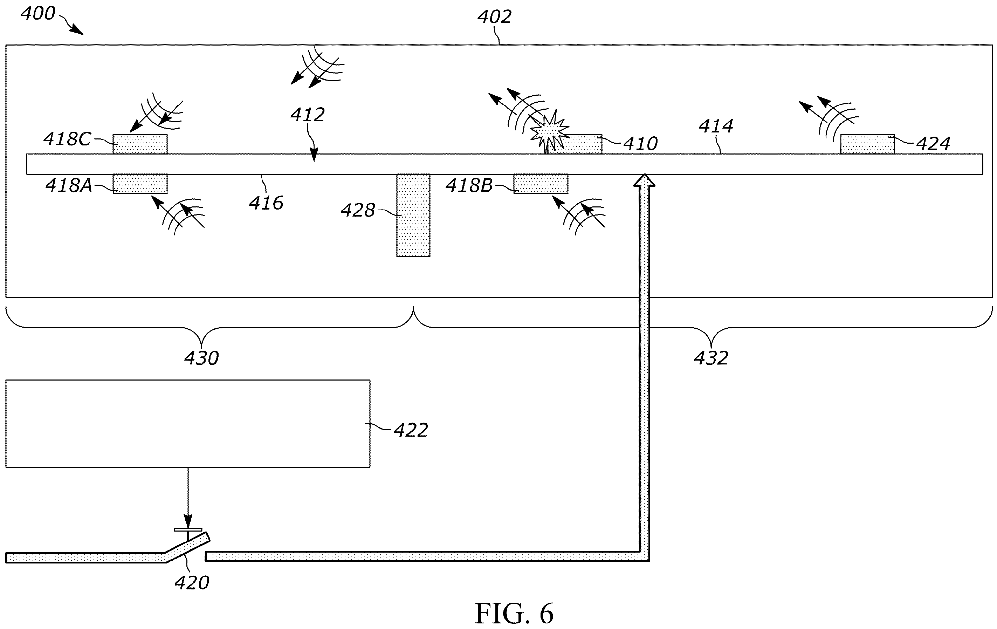

FIG. 6 shows a system 400 involving a barrier 428 and a double-sided circuit board 412 in enclosed module 402. In this form, the barrier 428 may be disposed on one side 416, dividing the second side 416 of the circuit board 412 into a first area 430 and a second area 432. In this form, side 416 may include a first light sensor 418A disposed in the first area 430 of the second side 416 and a second light sensor 418B disposed in the second area 432 of the second side 416.

It should be understood that, while the embodiment shown in FIG. 6 includes a light sensor 418C, an electrical component 410, and a light source 424 on one side 414 of the circuit board 412 and two light sensors 418A, 418B and a barrier 428 on the other side 416 of the circuit board 412, any alternate suitable number, type, and/or configuration of components may be used. For example, in some forms, both the first side 414 and the second side 416 of the circuit board 412 might include a barrier 428. In addition, as with the other systems, it is generally contemplated that each light sensor 418A, 418B, 418C may act in concert with one or more control circuits 422 to trigger a certain action, such as, for example, sending an alert and/or triggering a switch 420 to disable power to the enclosed module 402.

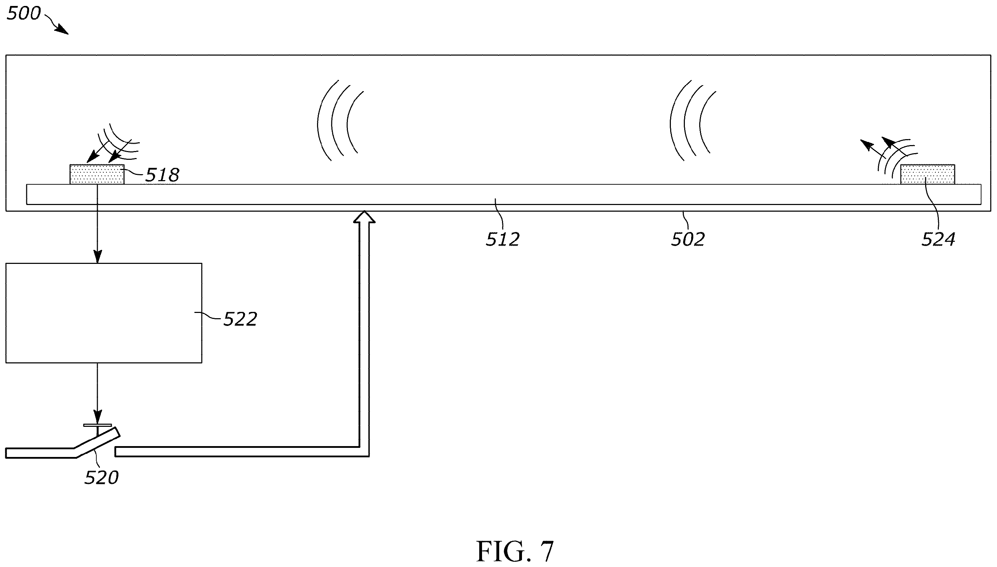

FIGS. 7-10 show a second approach to early detection and prevention of component failure in enclosed modules. Under this approach, the system seeks early detection of smoke, soot, or particulates in the enclosed module, not detection of an electrical arc, spark, or discharge. As addressed below this approach seeks to detect whether an expected light emission is obstructed in some manner in an enclosed module. It should be understood that this second approach may include some of the same or similar components as described in systems 100, 200, 300, and 400, which is incorporated into this description except to the extent differences are addressed below. Further, it should be understood that, although this second approach is generally addressed as an alternative to the first approach, it is also contemplated that they may be combined together to perform early detection in an enclosed module.

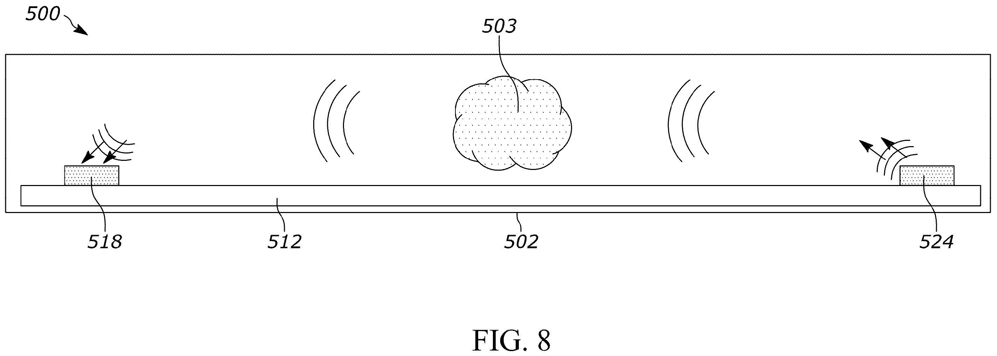

FIGS. 7 and 8 show a system 500 for the early detection of smoke, soot, and/or particulates within enclosures in accordance with some embodiments. In some forms, the system 500 includes an enclosed module 502, a light sensor 518, a control circuit 522, and a light source 524. The light source 524 in the enclosed module 502 may emit light continuously or at predetermined time intervals, such as, for example, every minute. In some forms, the light source 524 may be in the form of an LED and/or laser, although other types of light sources are also suitable. The light sensor 518 in the enclosed module 502 detects the light emitted by the light source 524.

As used herein, the terms "smoke", "soot", and "particulates" are generally used interchangeably to refer to material that may be obstructing detection of emitted light by the light sensor 518. Smoke, soot, and/or particulates generally refer to a suspension of carbon or other particles in the enclosed module, which may be emitted from a burning or smoldering electrical component. This material may have a concentration in the range of about 5-30 micrograms per cubic meter. In one form, for example, the light sensor 518 may be selected to detect light obstructed by a low concentration of particulates beginning in the range of about 5-15 micrograms per cubic meter. In another example, the light sensor 518 may be selected to detect light obstructed by a higher concentration of particulates beginning in the range of about 15-30 micrograms per cubic meter.

In some forms, the light sensor 518 and electrical components, such as shown in FIG. 2, may be mounted to a circuit board 512 in the enclosed module. In some forms, the circuit board may be double-sided, such as shown in FIGS. 4 and 6. In this form, it may include first side for mounting a first light source, a first light sensor, and a first set of electrical and/or electronic components, and it may include a second opposing side for mounting a second light source, a second light sensor, and a second set of electrical and/or electronic components. Also, it is generally contemplated that the enclosed module 502 may be a power distribution unit with a power input interface and one or more power output interfaces, such as output interface 108 shown in FIG. 1. In some forms, the light sensor 518 in combination with the control circuit 522 reacts in response to detection of the light emitted by the light source 524. In this regard, the control circuit 522 triggers a certain action upon the light detected by the light sensor 518 from the light source 524 being at least partially obstructed and falling below a certain, expected light threshold level, or light intensity.

FIG. 7 shows operation where there is no smoke event that may obstruct light from the light source 524 being detected by the light sensor 518. FIG. 8 shows a smoke event 503 that is, at least, partially obstructing the light detected by the light sensor 518. Once the light sensor 518 detects light falling below a certain light threshold level, or intensity, then the control circuit 522 triggers a predetermined response, which may be similar to the responses indicated above with respect to the first approach. In other words, the control circuit 522 is operatively coupled to the light sensor 518 and triggers the action upon detection of light by the light sensor 518 from the light source 524 falling below a certain light threshold level.

In one form, the predetermined action may be in the form of transmitting an alert indicating detection of the low light level detected by the light sensor 518. This alert may be transmitted to a system, such as, for example, one of the systems shown in Figure 1, e.g., Systems A, B, or C. Alternatively, or in addition, this alert may be transmitted to a centralized location, such as, for example, to the cockpit of an airplane. Also, the alert may be in any of various forms, such as, for example, a visual alert and/or an audio alert. It is generally contemplated that this alert may then result in an immediate action taken in response, such as, for example, some form of check on the status of the enclosed module 502 or shutdown of the enclosed module 502.

In some embodiments, such as shown in FIG. 7, the predetermined action may be an automated response to stop the supply of electrical power to the enclosed module 502, such as, for example, through the use of a switch 520. In one form, the switch 520 allows electrical power to be transmitted to the enclosed module 502 when in a first closed position but does not allow electrical power to be transmitted to the enclosed module 502 when in a second open position. In other words, when the switch 520 is in the closed position, the enclosed module 502 and the electrical components within the enclosed module 502 receive power and when the switch 520 is in the open position the enclosed module 502 and the electrical components within the enclosed module 502 do not receive power.

The control circuit 522 triggers a predetermined action based on the detection of light falling below an expected light threshold level. It is generally contemplated that this threshold level may be set or determined relative to a baseline light level, or intensity, measured at the light sensor 518 from pulses emitted by the light source 524 without smoke, soot, or particulates in the enclosed module 502. When detected light falls below this baseline light threshold level, a general determination is that this lower measured light level may be due to some obstruction, such as smoke, soot, or particulates.

It is generally contemplated that the system 500 may be set up to accommodate any of various types of light threshold levels. For example, the control circuit 522 may be triggered when detected light falls below a predetermined light threshold level as measured either instantaneously or over a certain length of time, when an average value of the detected light falls below the established light threshold level, or when detected light levels change at least by a certain minimum rate of change. Regarding a minimum rate of change, in some forms, for example, the light sensor 518 may take measurements at two or more discrete points of time, and a rate of change may be calculated. It may be desirable to act when there is a slow rate of change measured by the light sensor 518, such as, for example, 10 Lux/second, while in other forms, it may be desirable to act if there is a higher, or more significant, rate of change, such as, for example, 100 Lux/second. In one form, detection of this light level may trigger an alert.

In another form, in connection with the use of a switch 520, the control circuit 522 may trigger the switch 520 to the open position upon detection of the lower light level by the light sensor 518. In some examples, the control circuit 522 may trigger the switch 520 to the open position when the detected light falls below a predetermined light threshold level as measured over any amount of time or over a predetermined length of time. In some forms, the control circuit 522 may trigger the switch 520 to the open position when an average value of the detected light falls below a predetermined light threshold level. In some embodiments, the control circuit 522 of the system 500 may trigger the switch 520 to the open position when the detected light changes at least by a minimum rate of change. As with the first approach addressed earlier, it is preferably that the control circuit 522 trigger the predetermined action, such as transmitting an alert and/or activating a switch, immediately so as to avoid the spread of the cause of the smoke, soot, or other particulates to other components in the enclosed module 502 or to other systems outside of the enclosed module 502.

In some embodiments, the light source 524 may be used to act as a diagnostic or built-in test of the light sensor 518. In other words, the light source 524 may test the functionality and operation of the light sensor 518. In some embodiments, the control circuit 522 may signal an alert when the light sensor 518 fails to respond to the light emitted by the light source 524 over a predetermined length of time indicating non-functioning of the light sensor 518.

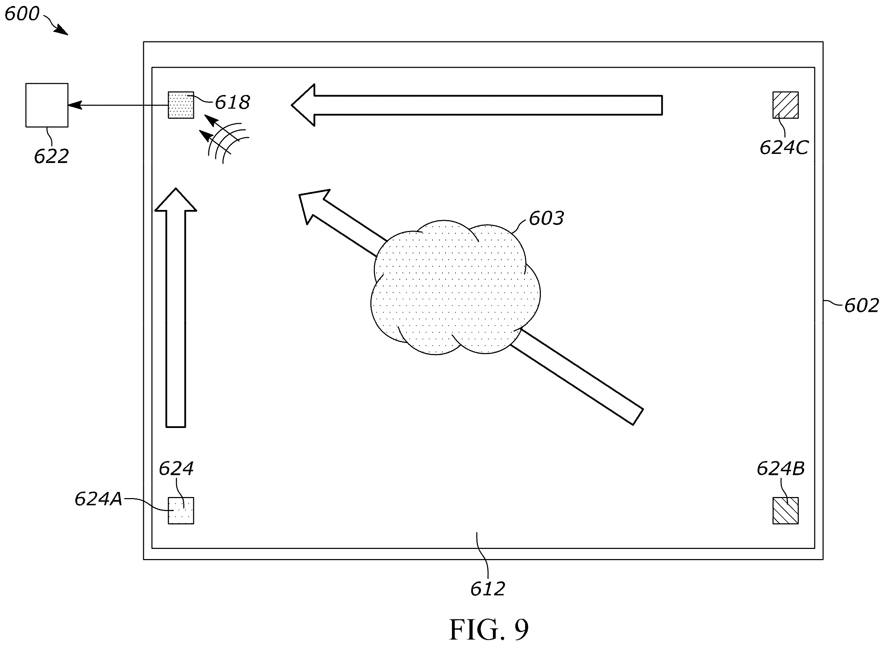

FIG. 9 shows an early detection system 600 including multiple light sources 624 in accordance with some embodiments. For example, in some forms, a first light source 624A may be mounted in a first area of the circuit board 612, and a second light source 624B may be mounted in a second area of the circuit board 612. Further, in some forms, the second light source 624B may emit light in sequence relative to the first light source 624A. In some examples, the light sensor 618 may detect light emitted by each of the first light source 624A and the second light source 624B. As addressed below, multiple light sources 624 may be used to triangulate the location of the smoke event 603 within the enclosed module 602.

In some forms, the control circuit 622 may compare a first light level emitted by the first light source 624A to a predetermined light threshold level associated with the first light source 624A. In some forms, the control circuit 622 may compare a second light level emitted by the second light source 624B to a predetermined light threshold level associated with the second light source 624B. Further, in some embodiments, the control circuit 622 is configured to triangulate a location of smoke, soot, or particulates in the enclosed module 602 based on the first light level emitted by the first light source 624A and based on the second light level emitted by the second light source 624B.

In some forms, the system 600 may include a second light sensor that detects light emitted by each of the first light source 624A and the second light source 624B. Further, in some forms, the control circuit 622 of the system 600 may triangulate the location of smoke, soot, or particulates in the enclosed module 602 based on light received by both the first and second light sensors. It is generally contemplated that the system 600 may include any desired number and arrangement of light sensors 618 and light sources 624.

In the embodiment shown in FIG. 9, the system 600 includes three light sources 624A, 624B, 624C each located at a respective corner/area on the circuit board 612. In the described embodiment, the light sensor 618 may detect light emitted by each of the first light source 624A, the second light source 624B, and the third light source 624C. In some forms, each light source 624A, 624B, 624C may be flashed or pulsed in a certain sequence relative to the others and measured against an individual baseline, or light intensity. In some examples, using multiple light sources 624 and selectively positioning each of the light sources 624 on the circuit board 612 allows the location of the smoke event 603 to be determined by calculation of the control circuit 622. In this example, as can be seen, the smoke event 603 is obstructing light emitted by light source 624B but is not obstructing lighted emitted by light sources 624A, 624C.

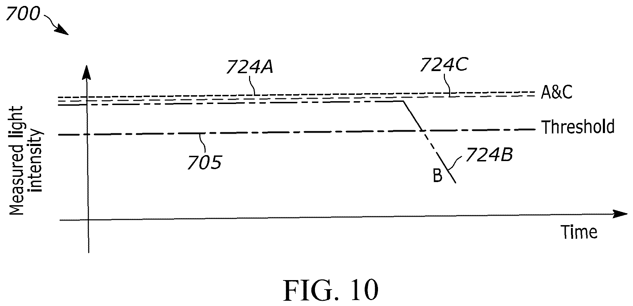

FIG. 10 shows a graph 700 which compares measured light intensity over time for light sources 624 of the system 600, which is shown in FIG. 9. The graph 700 shows the light intensity 724A of the first light source 624A, the light intensity 724B of the second light source 624B, and the light intensity 724C of the third light source 624C, as measured by light sensor 618. It also shows a predetermined light threshold level 705 in the form of a dashed line. The graph 700 further shows the measured light intensity 724B of the light source 624B dropping below the predetermined light threshold level 705, while the measured light intensities 724A, 724C of the light sources 624A, 624C are unaffected and remains above the threshold. These results indicate that the smoke event 603 is obstructing light from light source 624B but is not obstructing light from light sources 624A, 624C. This information can be used to determine and triangulate the general location of the smoke event 603 in the enclosed module 602.

In some forms, it is contemplated that data may be collected that may be used to investigate the smoke event 603 after it has occurred. Data received at one or more light sensors 618 may be recorded and used to determine a possible starting point of the smoke event 603 and to determine changes in volume and density of the smoke. In some forms, placing light sources 624 in multiple places throughout the enclosed module 602 allows the control circuit 622 to triangulate the location of smoke based on changes in the light intensity sensed from each light source 624.

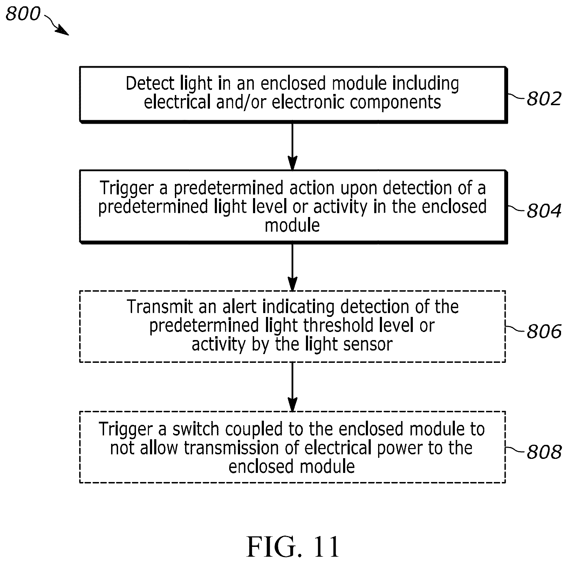

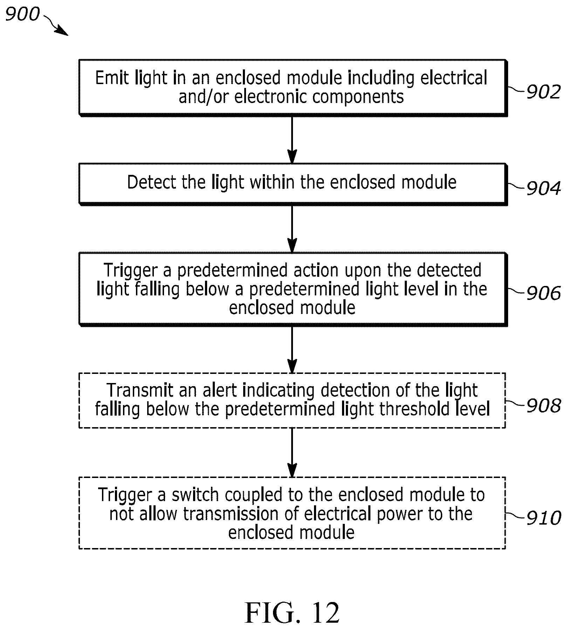

FIGS. 11 and 12 are flow diagrams showing certain steps of processes corresponding to the first and second early detection approaches addressed above. FIG. 11 shows a process 800 of detecting electrical component failures or electrical arcs in accordance with some embodiments. In one form, it is contemplated that the enclosed module is a power distribution unit in a high current, high voltage setting, such as, for example, an airplane application. The process 800 may use some or all of the components described above in connection with systems 100, 200, 300, and 400.

At block 802, light emitted within an enclosed module comprising a plurality of electrical and/or electronic components is detected. It is generally contemplated that it is detected by a light sensor in the enclosed module, which is operatively coupled to a control circuit. At block 804, a predetermined action is triggered by the control circuit upon the detection of a predetermined light level or activity in the enclosed module. This detected light may indicate an electrical arc, spark, or discharge that may prompt action.

Blocks 806 and 808 show possible actions taken in response to the detection of the predetermined light level or activity in the enclosed module. At block 806, in one form, an alert is triggered indicating detection of the predetermined light threshold level or activity by the light sensor. This alert may prompt responsive action. At block 808, a switch coupled to the enclosed module is triggered to not allow transmission of electrical power to the enclosed module. Further, it is generally contemplated that the process 800 may also include the additional operations and actions described above in connection with systems 100, 200, 300, and 400.

FIG. 12 shows a process 900 of detecting smoke, soot, or particulates in enclosed modules in accordance with some embodiments. In one form, it is contemplated that the enclosed module is a power distribution unit in a high current, high voltage setting, such as, for example, an airplane application. The process 900 may use some or all of the components described above in connection with systems 500 and 600.

At block 902, light is emitted in an enclosed module that includes electrical and/or electronic components. It is generally contemplated that the light is continuously or at predetermined time intervals, such as, for example, by an LED or laser. At block 904, the light is detected in the enclosed module. It is generally contemplated that the light is detected by a light sensor in the enclosed module, which is operatively coupled to a control circuit. At block 906, a predetermined action is triggered by the control circuit upon the detected light falling below a predetermined light threshold level, or intensity. In one form, the predetermined light threshold level may correspond to a baseline level measured when the light sensor is exposed to light from the light emitter. In this form, any deviation from the baseline may trigger action. In other forms, the threshold may be set to a certain level below the baseline, such as, for example, 100-500 Lux below the baseline, to seek to avoid false positive action. This measurement may indicate the presence of smoke, soot, or particulates in the enclosed module obstructing the light sensor and may prompt action.

Blocks 908 and 910 show possible actions taken in response to the emitted light falling below the predetermined light level in the enclosed module. At block 908, in one form, an alert is triggered indicating detection of the emitted light below the predetermined light threshold level. This alert may prompt responsive action. At block 910, a switch coupled to the enclosed module is triggered to not allow transmission of electrical power to the enclosed module. Further, it is generally contemplated that the process 900 may also include the additional operations and actions described above in connection with systems 500 and 600.

The above approaches are advantageous for high-voltage, high-current applications that involve enclosed modules with electrical components, such as for aviation applications. In some embodiments, the system can help detect arcing components that may cause sparks or discharge within an enclosed module. The system may use a light sensor that may be arranged in the enclosed module with a certain threshold level to detect sparks or discharge. Further, in some embodiments, the system can help detect smoke, soot, and/or particulates that may result from electrical components in an enclosed module. The system may use a light emitter and a light sensor that may be arranged in the enclosed module to detect smoke, soot, and/or particulates, rather than conventional smoke detectors.

Further aspects of the disclosure are provided by the subject matter of the following clauses:
There is provided a system for detecting electrical component failures or electrical arcs, the system including: an enclosed module comprising a plurality of electrical components; a first light sensor in the enclosed module, the first light sensor detecting light emitted within the enclosed module; and a control circuit operatively coupled to the first light sensor, the control circuit triggering a predetermined action upon detection of light in excess of a predetermined light threshold level or detection of predetermined light activity by the first light sensor.

The system of the preceding clause may further include: a switch coupled to the enclosed module, the switch electrically coupling the enclosed module to a power source in a first closed position and electrically uncoupling the enclosed module to the power source in a second open position; wherein the control circuit is operatively coupled to the switch, the predetermined action comprising triggering the switch to the second open position to electrically uncouple the enclosed module from the power source upon detection of light in excess of the predetermined light threshold level or detection of the predetermined light activity by the first light sensor.

The system of one or more of the preceding clauses may further include that the predetermined action includes transmitting an alert indicating detection of light in excess of the predetermined light threshold level or detection of the predetermined light activity by the first light sensor.

The system of one or more of the preceding clauses may further include that the enclosed module includes a power distribution unit including a power input interface and one or more power output interfaces.

The system of one or more of the preceding clauses may further include that the first light sensor is configured to uninterruptedly monitor visible background light in the enclosed module.

The system of one or more of the preceding clauses may further include that the enclosed module includes at least one interior surface reflecting light emitted by an electrical component to the first light sensor.

The system of one or more of the preceding clauses may further include that the enclosed module includes a circuit board coupled to the first light sensor and the plurality of electrical components.

The system of one or more of the preceding clauses may further include that the circuit board includes: a first side coupled to the first light sensor and a first set of electrical components; and a second side opposite the first side, the second side coupled to a second light sensor and a second set of electrical components.

The system of one or more of the preceding clauses may further include: a barrier dividing the circuit board into a first area and a second area; the first light sensor being mounted in the first area and detecting light emitted by electrical components in the first area; and a second light sensor being mounted in the second area and detecting light emitted by electrical components in the second area.

The system of one or more of the preceding clauses including that the control circuit is configured to trigger the predetermined action when the detected light exceeds the predetermined light threshold level for any length of time or as measured over a predetermined length of time.

The system of one or more of the preceding clauses may further include that the control circuit is configured to trigger the predetermined action when an average value of the detected light exceeds the predetermined light threshold level.

The system of one or more of the preceding clauses may further include that the control circuit is configured to trigger the predetermined action when the detected light changes in excess of a predetermined rate of change.

The system of one or more of the preceding clauses may further include a light source emitting a pulse of light at periodic time intervals in the enclosed module to test a functionality and an operation of the first light sensor.

The system of one or more of the preceding clauses may further include that the control circuit is configured to signal an alert when the first light sensor fails to respond to light emitted by the light source for any length of time or over a predetermined length of time.

The system of one or more of the preceding clauses may further include that the light source includes an LED or a laser.

There is further provided a method of detecting electrical component failures or electrical arcs, the method including: by a control circuit, receiving signals corresponding to light that is detected by a light sensor within an enclosed module comprising a plurality of electrical components; and by the control circuit, triggering a predetermined action upon detection of light in excess of a predetermined light threshold level or detection of predetermined light activity in the enclosed module.

The method of the preceding clause may further include that the predetermined action includes triggering a switch coupled to the enclosed module, the switch having a first closed position and a second open position, to the second open position to not allow transmission of electrical power to the enclosed module upon detection of light in excess of a predetermined light threshold level or detection of predetermined light activity by the first light sensor, the switch allowing electrical power to be transmitted to the enclosed module in the first closed position and not allowing electrical power to be transmitted in the second open position.

The method of one or more of the preceding clauses may further include that the predetermined action includes transmitting an alert indicating detection of light in excess of the predetermined light threshold level or detection of the predetermined light activity by the first light sensor.

The method of one or more of the preceding clauses may further include that the control circuit is configured to trigger the predetermined action when the detected light exceeds the predetermined light threshold level for any length of time or as measured over a predetermined length of time.

The method of one or more of the preceding clauses may further include, by a light source, emitting a pulse of light at periodic time intervals in the enclosed module to test a functionality and an operation of the light sensor.

A system for detecting smoke, soot, or particulates within enclosures, the system comprising: an enclosed module comprising a plurality of electrical components; a first light source in the enclosed module, the first light source emitting light continuously or at predetermined time intervals; a first light sensor in the enclosed module, the first light sensor detecting light emitted by the first light source; and a control circuit operatively coupled to the first light sensor, the control circuit triggering a predetermined action upon light detected by the first light sensor from the first light source being at least partially obstructed and falling below a predetermined light threshold level.

The system of any preceding clause, further comprising: a switch coupled to the enclosed module, the switch electrically coupling the enclosed module to a power source in a first closed position and electrically uncoupling the enclosed module to the power source in a second open position; wherein the control circuit is operatively coupled to switch, the predetermined action comprising triggering the switch to the second open position to electrically uncouple the enclosed module from the power source upon light detected by the first light sensor from the first light source being at least partially obstructed and falling below the predetermined light threshold level.

The system of any preceding clause, wherein the predetermined action comprises transmitting an alert indicating detection of light by the first light sensor from the first light source falling below the predetermined light threshold level.

The system of any preceding clause, wherein the enclosed module comprises a power distribution unit including a power input interface and one or more power output interfaces.

The system of any preceding clause, wherein the enclosed module further comprises a circuit board coupled to the first light sensor and the plurality of electrical components.

The system of any preceding clause, wherein the circuit board further comprises: a first side coupled to the first light source, the first light sensor, and a first set of electrical components; and a second side opposite the first side, the second side coupled to a second light source, a second light sensor, and a second set of electrical components.

The system of any preceding clause, wherein: the first light source is mounted in a first area of the circuit board; a second light source is mounted in a second area of the circuit board and emits light in sequence relative to the first light source; and the first light sensor detects light emitted by each of the first light source and the second light source.

The system of any preceding clause, wherein the control circuit is configured to: compare a first light level emitted by the first light source to a predetermined light threshold level associated with the first light source; compare a second light level emitted by the second light source to a predetermined light threshold level associated with the second light source; and triangulate a location of smoke, soot, or particulates in the enclosed module based on the first light level emitted by the first light source and based on the second light level emitted by the second light source.

The system of any preceding clause, further comprising: a second light sensor detecting light emitted by each of the first light source and the second light source, the control circuit configured to triangulate the location of smoke, soot, or particulates in the enclosed module based on light received by both the first light sensor and the second light sensor.

The system of any preceding clause, wherein the control circuit is configured to trigger the predetermined action when detected light falls below the predetermined light threshold level for any length of time or as measured over a predetermined length of time.

The system of any preceding clause, wherein the control circuit is configured to trigger the predetermined action when an average value of detected light falls below the predetermined light threshold level.

The system of any preceding clause, wherein the control circuit is configured to signal an alert when the first light sensor fails to respond to light emitted by the first light source over a predetermined length of time indicating non-functioning of the first light sensor.

The system of any preceding clause, wherein the first light source comprises an LED or a laser.

The system of any preceding clause, wherein the predetermined light threshold level is determined relative to a baseline light level measured at the first light sensor from pulses emitted by the first light source without smoke, soot, or particulates in the enclosed module.

A method of detecting smoke, soot, or particulates in enclosures, the method comprising: by a control circuit, receiving signals corresponding to light that is detected by a light sensor in an enclosed module comprising a plurality of electrical components, a first light source emitting light continuously or at predetermined time intervals in the enclosed module; and by the control circuit, triggering a predetermined action upon light detected by the light sensor from the first light source being at least partially obstructed and falling below a predetermined light threshold level.

The method of any preceding clause, wherein: the predetermined action comprises triggering a switch coupled to the enclosed module, the switch having a first closed position and a second open position, to the second open position to not allow transmission of electrical power to the enclosed module upon light detected by the light sensor from the first light source being at least partially obstructed and falling below the predetermined light threshold level, the switch allowing electrical power to be transmitted to the enclosed module in the first closed position and not allowing electrical power to be transmitted in the second open position.

The method of any preceding clause, wherein the predetermined action comprises triggering an alert indicating detection of light by the light sensor from the first light source falling below a predetermined light threshold level.

The method of any preceding clause, further comprising: by a second light source in the enclosed module, emitting light continuously or at predetermined time intervals; and by the light sensor, detecting light emitted by each of the first light source and the second light source.

The method of any preceding clause, further comprising, by the control circuit: comparing a first light level emitted by the first light source to a predetermined light threshold level associated with the first light source; comparing a second light level emitted by the second light source to a predetermined light threshold level associated with the second light source; and triangulating a location of smoke, soot, or particulates in the enclosed module based on the first light level emitted by the first light source and based on the second light level emitted by the second light source.

The method of any preceding clause, wherein the control circuit is configured to trigger the predetermined action when detected light falls below the predetermined light threshold level for any length of time or as measured over a predetermined length of time.

It will be understood that various changes in the details, materials, and
arrangements of parts and components which have been herein described and illustrated to explain the nature of the disclosure may be made by those skilled in the art within the principle and scope of the appended claims. Furthermore, while various features have been described with regard to particular embodiments, it will be appreciated that features described for one embodiment also may be incorporated with the other described embodiments.

## Claims

1. A system (100, 200) for detecting electrical component failures or electrical arcs, the system (100, 200) comprising:
an enclosed module (102, 202) comprising a plurality of electrical components (110);
a first light sensor (118, 218A) in the enclosed module (102, 202), the first light sensor (118, 218A) detecting light emitted within the enclosed module (102, 202); and
a control circuit (122, 222) operatively coupled to the first light sensor (118, 218A), the control circuit (122, 222) triggering a predetermined action upon detection of light in excess of a predetermined light threshold level or detection of predetermined light activity by the first light sensor (118, 218A).

2. The system (100, 200) of claim 1, further comprising:
a switch (120, 220) coupled to the enclosed module (102, 202), the switch (120, 220) electrically coupling the enclosed module (102, 202) to a power source (104) in a first closed position and electrically uncoupling the enclosed module (102, 202) to the power source (104) in a second open position;
wherein the control circuit (122, 222) is operatively coupled to the switch (120, 220), the predetermined action comprising triggering the switch (120, 220) to the second open position to electrically uncouple the enclosed module (102, 202) from the power source (104) upon detection of light in excess of the predetermined light threshold level or detection of the predetermined light activity by the first light sensor (118, 218A).

3. The system (100, 200) of claims 1 or 2, wherein the predetermined action comprises transmitting an alert indicating detection of light in excess of the predetermined light threshold level or detection of the predetermined light activity by the first light sensor (118, 218A).

4. The system (100, 200) of any of the preceding claims, wherein the enclosed module (102, 202) comprises at least one interior surface (126, 226) reflecting light emitted by an electrical component (110) to the first light sensor (118, 218A).

5. The system (100, 200) of any of the preceding claims, wherein the enclosed module (102, 202) further comprises a circuit board (112, 212) coupled to the first light sensor (118, 218A) and the plurality of electrical components (110).

6. The system (100, 200) of claim 5, wherein the circuit board (112, 212) further comprises:
a first side coupled to the first light sensor (118, 218A) and a first set of electrical components (110, 210A); and
a second side opposite the first side, the second side coupled to a second light sensor (118, 218B) and a second set of electrical components (110, 210B).

7. The system (100, 200) of claim 5, wherein:
a barrier (328, 428) divides the circuit board (112, 212) into a first area and a second area;
the first light sensor (118, 218A, 318A) is mounted in the first area and detects light emitted by electrical components (110) in the first area; and
a second light sensor (318B) is mounted in the second area and detects light emitted by electrical components (110) in the second area.

8. The system (100, 200) of any of the preceding claims, wherein the control circuit (122, 222) is configured to trigger the predetermined action when detected light exceeds the predetermined light threshold level for any length of time or as measured over a predetermined length of time.

9. The system (100, 200) of any of claims 1 to 7, wherein the control circuit (122, 222) is configured to trigger the predetermined action when an average value of detected light exceeds the predetermined light threshold level.

10. The system (100, 200) of any of claims 1 to 7, wherein the control circuit (122, 222) is configured to trigger the predetermined action when detected light changes in excess of a predetermined rate of change.

11. The system (100, 200) of any of the preceding claims, further comprising a light source (124) emitting a pulse of light at periodic time intervals in the enclosed module (102, 202) to test a functionality and an operation of the first light sensor (118, 218A).

12. The system (100, 200) of claim 11, wherein the control circuit (122, 222) is configured to signal an alert when the first light sensor (118, 218A) fails to respond to light emitted by the light source (124) for any length of time or over a predetermined length of time.

13. A method (800) of detecting electrical component failures or electrical arcs, the method comprising:
by a control circuit (122, 222), receiving signals corresponding to light that is detected by a light sensor (118, 218A) within an enclosed module (102, 202) comprising a plurality of electrical components (110); and
by the control circuit (122, 222), triggering a predetermined action upon detection of light in excess of a predetermined light threshold level or detection of predetermined light activity in the enclosed module (102, 202).

14. The method (800) of claim 13, wherein:
the predetermined action comprises triggering a switch (120, 220) coupled to the enclosed module (102, 202), the switch (120, 220) having a first closed position and a second open position, to the second open position to not allow transmission of electrical power to the enclosed module (102, 202) upon detection of light in excess of a predetermined light threshold level or detection of predetermined light activity by the light sensor (118, 218A), the switch (120, 220) allowing electrical power to be transmitted to the enclosed module (102, 202) in the first closed position and not allowing electrical power to be transmitted in the second open position.

15. The method (800) of claims 13 or 14, wherein the predetermined action comprises transmitting an alert indicating detection of light in excess of the predetermined light threshold level or detection of the predetermined light activity by the light sensor (118, 218A).
